# EUROPEAN PATENT SPECIFICATION

(11) **EP 4 147 354 B1**
(45) Date of publication and mention of the grant of the patent: **27.05.2026**
(21) Application number: 21723393.1
(22) Date of filing: 28.04.2021
(51) Int. Cl.: H03K 19/003, H03M 9/00, H04L 25/40

(54) **IMPROVED INTEGRATED CIRCUIT FOR DRIVING FAST LINKS IN RADIATIONHARD APPLICATIONS**
VERBESSERTE INTEGRIERTE SCHALTUNG ZUR STEUERUNG SCHNELLER VERBINDUNGEN IN STRAHLUNGSBÄRANWENDUNGEN
CIRCUIT INTÉGRÉ AMÉLIORÉ DESTINÉ À CONDUIRE DES LIAISONS RAPIDES DANS DES APPLICATIONS DURCIES CONTRE LES RAYONNEMENTS

(30) Priority: 04.05.2020 IT 202000009640
(43) Date of publication of application: 15.03.2023
(73) Proprietor: Universita' di Pisa, 56126 Pisa (IT); Istituto Nazionale di Fisica Nucleare, 00044 Frascati (RM) (IT)
(72) Inventor: SAPONARA, Sergio, 56124 Pisa (Pisa) (IT); CIARPI, Gabriele, 56124 Pisa (IT); MAGAZZÙ, Guido, 00044 Frascati (Roma) (IT); PALLA, Fabrizio, 00044 Frascati (Roma) (IT)
(74) Representative: Lunati & Mazzoni S.r.L.
(86) International application number: PCT/IB2021/053519
(87) International publication number: WO 2021/224727

(56) References cited:
- US-A1- 2006 029 176
- US-B1- 8 624 761
- RAFFAELE GIORDANO ET AL: "Fixed-Latency, Multi-Gigabit Serial Links With Xilinx FPGAs", IEEE TRANSACTIONS ON NUCLEAR SCIENCE, IEEE SERVICE CENTER, NEW YORK, NY, US, vol. 58, no. 1, 1 February 2011 (2011-02-01), pages 194 - 201, XP011334607, ISSN: 0018-9499, DOI: 10.1109/TNS.2010.2101083
- WILSON ANTHONY ET AL: "Radiation Effects Characterization of a 3.125Gbps 90nm SerDes IP", 2015 IEEE RADIATION EFFECTS DATA WORKSHOP (REDW), IEEE, 13 July 2015 (2015-07-13), pages 1 - 5, XP032824168, ISBN: 978-1-4673-7641-9, [retrieved on 20151124], DOI: 10.1109/REDW.2015.7336728

## Description

The present invention relates to an improved integrated circuit for driving fast links in radiation-hard applications of the type specified in the preamble of the first claim. In particular, the present invention relates to an improved integrated circuit for applications such as space, in the field of high-energy physics and nuclear medicine where electronic circuits and systems are affected by problems mainly related to Single Event Effects, or SEE, and from degradation by Total Ionization Dose, or TID. As is known, integrated circuits for radiation-hard or rad-hard applications are affected by malfunctioning and performance deterioration phenomena due to the interaction between the radiations and the devices that implement the circuits.

In particular, some of the malfunction phenomena are generically referred to as Single Event Effects, or SEE, and substantially derive from the crossing of a semiconductor by a high-energy particle.

In fact, when a high-energy particle travels through a semiconductor, it leaves behind an ionized trace that can cause highly localized effects such as glitches in voltages and currents, bit reversal in register memories, destructive latchups and burnouts.

The SEEs are of utmost importance for electronics in satellites, aircraft and other civil and military aerospace applications, as well as nuclear, and cause single or multiple transmission errors in devices intended for high-speed data transmission. Long-term phenomena of deterioration in performance are those due to Total Ionizing Dose, or TID. The TIDs are cumulative damage to the semiconductor lattice caused by ionizing radiation over the exposure time.

In particular, it causes a slow degradation of the performance of the device including the circuit. In CMOS devices, for example, the radiation causing TID effects in the integrated circuit creates, in detail, electron-hole pairs in the gate insulation layers, and the gaps trapped in the lattice defects in the insulator create persistent gate polarization and influence the threshold voltage of the transistors, making N-type MOSFET transistors easier and P-type more difficult to turn on.

In high-speed data transmission devices, The TIDs are primarily responsible for variations in voltage levels and also for reductions in data transmission speeds. Integrated circuits for driving fast links include Serializer-Deserializer, or SERDES, functions implemented by Parallel In Serial Out, or PISO, and Serial In Parallel Out, or SIPO modules.

Furthermore, the PISO module usually uses a Phase-Locked-Loop device, or PLL, which is a system that generates an output signal whose frequency and phase are correlated to those of a reference input signal. The frequency of the reference signal is multiplied until the required frequency in the PISO module is obtained for the serial output clock. The PISO module has a set of data lines at its input, together with the parallel and serial clock signals.

The simplest form of PISO has a single shift register, or SHR, determined by a chain of cascaded flip-flops that share the same serial clock signal to move the incoming data along the chain which changes with each transition of the parallel clock signal. In other words, the PISO receives a new parallel data at each parallel clock cycle and moves it along the chain, generating a different bit at each serial clock cycle. The SIPO module has one serial data line and one serial clock at its input and a set of output data lines.

Generally, the clock signal reception is reconstructed via a Clock and Data Recovery block, or CDR, starting from the serial data. In particular, the CDR is implemented in such a way that starting from a reference clock with an approximate frequency, a reception clock with a frequency equal to the serial one used in transmission and aligned in phase with the transitions with the incoming data. Even the SIPO in its simplest form has a single shift register, or SHR, consisting of a chain of cascaded flip-flops that share the same serial clock signal to move the incoming serial data along the chain. A new parallel data will be sampled at each cycle of the parallel clock and made available on the output data lines.

In particular, during the synchronization phase of the devices, great care is required in the generation of the parallel clock that drives the PISO and SIPO modules and the basic logic, or core logic, both in transmission and reception. Synchronization can be achieved with two main techniques, bearing in mind that the high frequency clock signal output from the PLL and CDR modules must maintain a stable frequency correlation with respect to the parallel clock signal used in the PISO and SIPO modules. Both clock signals should be protected from SEE effects which could induce spurious or missing clock cycles.

According to a first technique, the reference clock signal of the PLL module is used as a parallel clock by the basic logic and by the PISO and SIPO modules in such a way as not to require additional components for the generation of basic logic clock signals related to the high frequency signal of the PLL.

However, this technique has the important drawback of imposing severe limitations on the size of the data strings, or rather on the number of bits, and on the data transmission speed. In many cases there is no freedom in choosing the frequency of the reference signal for certain PLL devices. For example, for a PLL that requires a 66.67 MHz reference clock to generate a 4 GHz output clock, the width of the word, or string, of data from the main logic to the Serializer must be 60. Therefore, in general, the main drawback of this technique is the reduced flexibility since the reference clock and the base logic clock necessarily coincide.

An alternative technique, known and currently used, provides for the generation of the clock signal of the basic logic and of the PISO and SIPO modules by means of a Frequency Divider, or FD, integrated within the Serializer, or of the Deserializer, implemented with Shift Registers, or SHR, and capable of obtaining the desired frequency ratio with the high frequency clock output from the PLL and CDR modules. This solution is much more versatile than the first technique presented, however the obvious drawback is the fact that an FD must necessarily be integrated into the Serializer, or the Deserializer, in order to generate a clock signal for the basic logic and for the PISO and SIPO modules that are stably correlated in frequency with the high frequency signals output from the PLL and CDR modules. In order to solve the problems caused by SEE and TID, the integrated circuits for driving fast links, which include synchronized SERDES functions, are made according to constructive procedural logics aimed at making the electronic components and circuits resistant to damage or malfunctions caused by high levels of ionizing radiation. These processes are defined as "radiation hardening".

The radiation hardening, or the increase in the robustness of the circuit, is only achieved, in the case of synchronized devices as described above, by adopting redundant logics in which the SHRs are equipped with double or triple chains of flip-flops which therefore have great impact both in terms of space consumption and in terms of energy consumption.

In this situation, the technical task underlying the present invention is to devise an improved integrated circuit for driving fast links in applications radiation-hard capable of substantially obviating at least part of the aforementioned drawbacks. Within the scope of said technical task, it is an important object of the invention to obtain an improved integrated circuit which is able to efficiently mitigate the deterioration effects deriving from radiations which strike the circuit, in particular SEE and TID. The document of RAFFAELE GIORDANO ET AL: "Fixed-Latency, Multi-Gigabit Serial Links With Xilinx FPGAs",IEEE TRANSACTIONS ON NUCLEAR SCIENCE, IEEE SERVICE CENTER, NEW YORK, NY, US, vol. 58, no. 1, 1 February 2011 (2011-02-01), pages 194-201, addresses the issue of non-deterministic latency in FPGA-based high-speed serial links, particularly in systems requiring precise timing, such as those in high-energy physics. The authors present a technique using Xilinx GTP transceivers, where both the transmitter and receiver are configured to ensure fixed latency through elastic buffer bypassing and controlled phase alignment. A custom alignment logic synchronizes deserialized data with the system clock. The solution was implemented and tested on Virtex-5 FPGAs with 2.5 Gbps links, showing stable, repeatable latency with minimal jitter. The method is protocol-independent and adaptable to newer Xilinx FPGA families, offering a robust solution for timing-critical applications.

Another important object of the invention is to provide an improved integrated circuit that avoids redundant logics in such a way as to reduce waste of space or non-essential energy.

In conclusion, an important task of the invention is to provide an improved integrated circuit for driving fast links in applications radiation-hard that is able to autonomously restore its functionality in accordance with the specifications even in the event of deterioration in performance due to TID effects.

The technical task and the specified aims are achieved by an improved integrated circuit for driving fast links in radiation-hard applications as claimed in the attached claim 1.

Preferred technical solutions are highlighted in the dependent claims.

The characteristics and advantages of the invention are clarified below by the detailed description of preferred embodiments of the invention, with reference to the accompanying figures, in which:

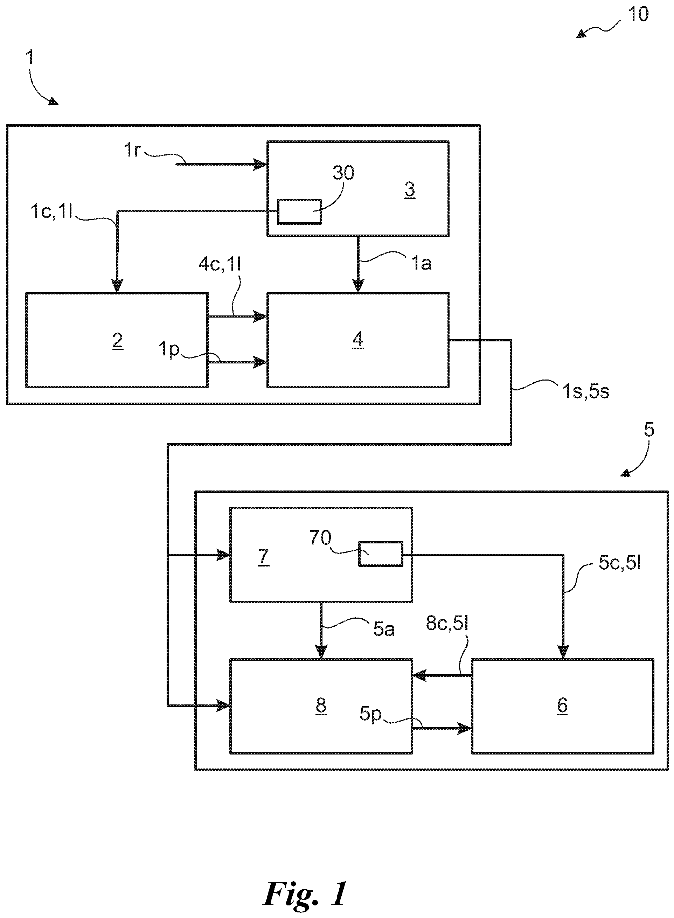

the **Fig. 1** shows a functional diagram of an integrated circuit for improved fast link piloting in radiation-hard applications according to the invention;
the **Fig. 2** illustrates a functional diagram of a PISO device included in an integrated circuit for improved fast link piloting in radiation-hard applications according to the invention;
the **Fig. 3** is a functional diagram of a SIPO device included in an integrated circuit for improved fast link piloting in radiation-hard applications according to the invention;

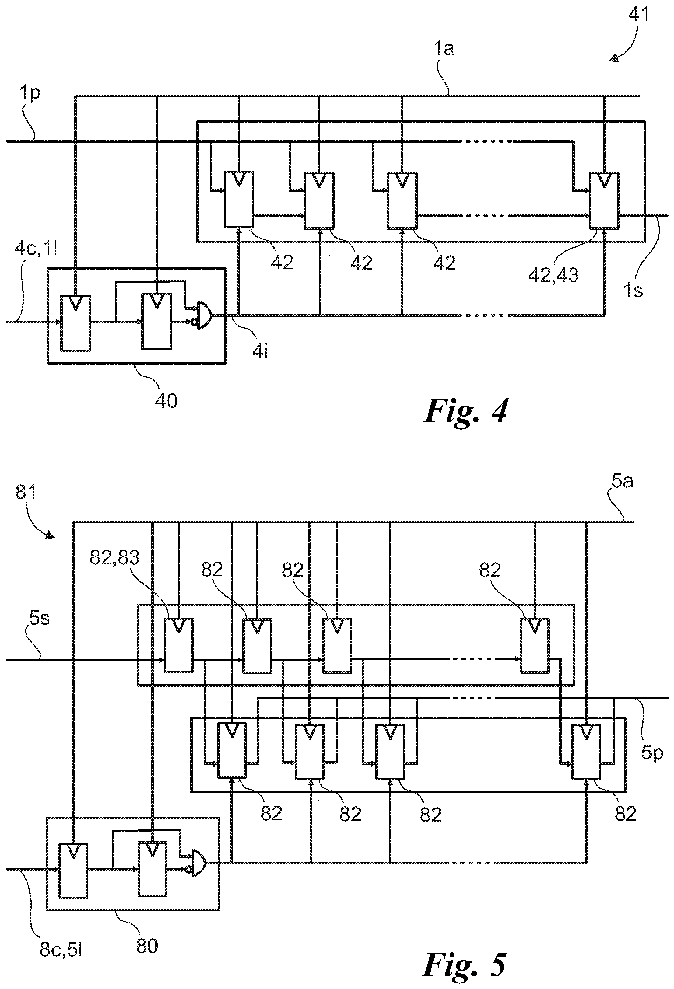

the **Fig. 4** is a functional diagram of a shift register included in a Serializer PISO of a device included in an integrated circuit for improved fast link piloting in radiation-hard applications according to the invention;
the **Fig. 5** shows a functional diagram of a shift register included in a Deserializer SIPO of a device included in an integrated circuit for improved fast link piloting in radiation-hard applications according to the invention;
the **Fig. 6a** illustrates a functional diagram of a flip-flop transmitter, in a main embodiment, comprised in a Serializer PISO of a device included in an integrated circuit for improved fast link piloting in radiation-hard applications according to the invention; and
the **Fig. 6b** is a functional diagram of a flip-flop transmitter, in an alternative embodiment, included in a Serializer of a PISO device included in an integrated circuit improved for fast link piloting in radiation-hard applications according to the invention.

In the present document, the measurements, values, shapes and geometric references (such as perpendicularity and parallelism), when associated with words like "about" or other similar terms such as "approximately" or "substantially", are to be considered as except for measurement errors or inaccuracies due to production and/or manufacturing errors, and, above all, except for a slight divergence from the value, measurements, shape, or geometric reference with which it is associated. For instance, these terms, if associated with a value, preferably indicate a divergence of not more than 10% of the value.

Moreover, when used, terms such as "first", "second", "higher", "lower", "main" and "secondary" do not necessarily identify an order, a priority of relationship or a relative position, but can simply be used to clearly distinguish between their different components.

Unless otherwise specified, as results in the following discussions, terms such as "treatment", "computing", "determination", "calculation", or similar, refer to the action and/or processes of a computer or similar electronic calculation device that manipulates and/or transforms data represented as physical, such as electronic quantities of registers of a computer system and/or memories in, other data similarly represented as physical quantities within computer systems, registers or other storage, transmission or information displaying devices.

The measurements and data reported in this text are to be considered, unless otherwise indicated, as performed in the International Standard Atmosphere ICAO (ISO 2533:1975).

With reference to the figures, the improved integrated circuit for driving fast links in radiation-hard applications according to the invention is globally indicated with the number **10.**

The circuit 10 is, in particular, used to manage the transmission of information at high speed for applications of various kinds. For example, the circuit 10 can be used in applications such as space applications, in the field of high energy physics, nuclear medicine or so on.

In general, as already mentioned, such applications are often affected by deterioration phenomena deriving from the incidence of radiation on the components of the circuit 10.

In any case, the circuit 10 defines a SERDES system, or rather including at least one device configured to transform coded information multi-bit information into serial information and a device configured to convert it back into multi-bit encoded information.

In this regard, the circuit 10 therefore comprises devices capable of mutually interacting in such a way as to allow fast data transmission.

In particular, preferably, the circuit 10 comprises at least one PISO device 1.

The term PISO, acronym for Parallel-in-Serial-Out, refers to a device capable of receiving a plurality of data in parallel and converting them into serial data.

The PISO device 1, in fact, substantially includes the same components as the PISO devices of the known art, but with some important differences in terms of interconnection of the components of the PISO device 1 itself, as better specified below.

Preferably, the PISO device 1 comprises at least a transmitting block **2,** a PLL **3** and a Serializer **4.**

The transmitting block 2 is preferably the component of the PISO device 1 within which the basic logic is implemented. Therefore, the PISO device 1 defines a first basic logic and is configured to transmit first parallel data **1p** related to a first low frequency clock signal **1l.**

The first data can be of various kinds. Preferably, the data is encoded in the binary system and the amount of input data depends, as in any digital device, on the number of bits that the PISO 1 device is able to process.

The transmitting block 2 is, in any case, widely known in the current state of the art. The PLL 3, or Phase-Locked Loop, is configured to receive a reference clock signal **1r** and to generate at least one high frequency clock signal **1a.**

For this purpose, the PLL 3 has a conventional architecture. Therefore, the PLL includes at least one prime Frequency divider **30,** or FD. The first FD 30 is substantially configured to generate at least a first control clock signal **1c** starting from the first high frequency clock signal 1a.

For example, the first control clock signal 1c can be obtained by dividing the frequency value of the clock 1a by an integer proportional and in detail equal to the number of bits of the first data in parallel 1p.

Furthermore, the PLL preferably also includes a first PD **31,** or Phase Detector, a first LP **32,** or Low Pass Filter, a first CP **33,** or Charge Pump and a first VCO **34,** or Voltage Controlled Oscillator.

In detail, the first PD 31 receives the reference clock signal 1r and a clock signal from the first FD 30 and compares them in phase and frequency. The first LP 32 therefore filters the signals received from the first PD 31 in such a way that said filtered signals can control the first CP 33, so as to realize the control voltage to be imposed on the first VCO 34 which generates the first clock signal to high frequency 1a.

This architecture is, in itself, known to those skilled in the art.

The PLL 3, therefore, in summary, controls the first high frequency clock signal 1a as feedback by comparing in phase the first reference clock signal 1r and a first comparison clock signal **1f** derived from the first control clock signal 1c.

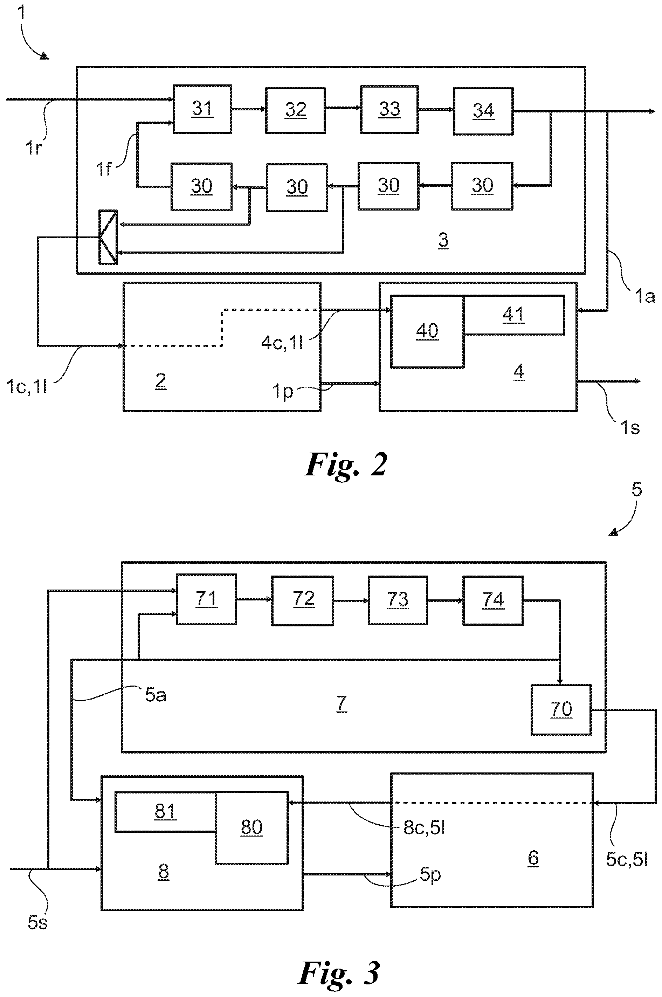

The first comparison clock signal 1f can substantially coincide, in a possible configuration with a single first FD 30, with the first control clock signal 1c. Or, preferably, the first comparison clock signal 1f can be the result of other frequency divisions in further first FD 30 starting, for example, from the first control signal 1c. The latter configuration is shown in Fig. 2.

Typically, the first comparison clock signal 1f is the signal that comes out of the last FD 30 and, therefore, can coincide with the lower frequency signal transmitted in the PLL 3.

The Serializer 4 is also mostly known to those skilled in the art.

In fact, it includes at least one first Shift Register **41.** The first Shift Register 41 comprises first flip-flops **42** cascaded. The first flip-flops 42 are substantially 1-bit memory cells arranged in a chain. The first Shift register 41 is substantially configured to shift the bits from one cell to the one immediately adjacent to each clock pulse.

The serializer 4 is preferably operatively connected to the transmitting block 2. Furthermore, the serializer 4 is configured to receive at least the first data in parallel 1p and the first high-frequency clock signal 1a.

Hence, the serializer 4 preferably rearranges the first parallel data 1p into first serial data **1s.** The first serial data 1s are only as high as the first parallel data 1p arranged in an orderly manner in a sequence that can be quickly transferred from Serializer 4, for example, to a Deserializer.

The first serial data 1s are, in the Serializer 4, preferably correlated in frequency to the first high frequency clock signal 1a.

Like every Serializer, moreover, the Serializer 4 substantially reorganizes the first parallel data 1p into first serial data 1s on the basis of a first load signal **4c.** Usually, the load signal is generated internally in the Serializer, however, this configuration has important drawbacks, as already mentioned, when the circuit 10 which includes the PISO device 1 is subjected to radiation.

The first load signal 4c is advantageously not generated internally in the Serializer 4.

Preferably, the first FD 30 is operatively connected to the transmitting block 2.

Furthermore, the first low frequency clock signal 11 coincides with the first clock control signal 1c.

Advantageously, the transmitting block 2 transmits the first low frequency clock signal 1l to the Serializer 4 so as to determine the first load signal 4c with the right relationship substantially proportionally to the first low frequency clock signal 11.

This last aspect is important since the first high frequency signal 1a and the first load signal 4c must have a suitable phase relationship to allow the correct loading of the signal 1p and the generation of the first serial data 1s.

In the PISO 1 device it is possible to determine this correspondence without resorting to the internal generation of the load signal with the use of additional modules sensitive to radiation.

Since, as already said, the first Shift Register 41 is configured to control the shifting of the bits between the first flip-flips 42 during the organization of the first parallel data 1p into first serial data 1s, preferably the Serializer 4 also comprises a first pulse generator module **40.**

The first pulse generator module 40 is operatively connected to the first FD 30. In particular, the first pulse generator module 40 is driven by the first low frequency clock signal 11 derived from the first control signal 1c generated by the first FD 30. Hence, the first pulse generator module 40 is configured to generate a first pulse **4i** along a clock cycle of the first high-frequency clock signal 1a at each rising edge of the first low-frequency clock signal 1l. This first pulse is therefore given by the first load signal 4c and determines the sliding in the first Shift Register 41.

The circuit 10, suitably, also comprises a SIPO device **5.**

The SIPO device is, in particular, configured to interact with the PISO device 1 in such a way as to exchange at least serial data between devices 1, 5.

The term SIPO, acronym for Serial-in-Parallel-Out, refers to a device capable of converting serial data into a plurality of data in parallel.

The SIPO device 5, in fact, substantially includes the same components as the SIPO devices of the known art, but with some important differences in terms of interconnection of the components of the SIPO device 5 itself, as better specified below.

Preferably, the SIPO device 5 comprises at least a receiving block **6,** a Clock and Data Recovery apparatus **7** and a Deserialzer **8.**

The receiving block 6 is preferably the component of the SIPO device 5 within which the basic logic is implemented. Therefore, the SIPO device 5 defines a second basic logic and is configured to receive second parallel data **5p** correlated to a second low frequency clock signal **5l.**

The second data can be data of various kinds. Preferably, the data is encoded in the binary system and the amount of input data depends, as in any digital device, on the number of bits that the SIPO device 5 is able to process.

The receiving block 6 is, in any case, widely known in the current state of the art. The Clock and Data Recovery 7, or CDR, apparatus is preferably configured to receive second serial data **5s** and to generate at least one high frequency clock signal **5a.**

Furthermore, the CDR apparatus 7 is configured to control in feedback the high frequency clock signal 5a by comparing in phase the high frequency clock signal 5a and the second serial data 5s.

For this purpose, the CDR apparatus 7 comprises a PLL having a conventional architecture. Therefore, the PLL included in the CDR 7 apparatus preferably includes at least a second PD **71,** or Phase Detector, a second LP **72,** or Low Pass Filter, a second CP **73,** or Charge Pump and a second VCO **74,** or Voltage Controlled Oscillator. These components in the CDR 7 apparatus substantially perform the same functions as the corresponding elements of the PLL 3.

In detail, the second PD 71 receives the serial data and the second high-frequency clock signal 5a, and compares them in phase and frequency. The second LP 72 therefore filters the signals received from the second PD 71 in such a way that said filtered signals can control the second CP 73, so as to realize the control voltage to be imposed on the second VCO 74 which generates the second clock signal to high frequency 5a.

This architecture is, in itself, known to those skilled in the art.

The CDR apparatus 7, therefore, in summary, controls the second high frequency clock signal 5a in feedback by comparing in phase the second high frequency clock signal 5a and the serial data 5s. In this way, the CDR apparatus 7 can reconstruct a high frequency clock signal 5a, possibly transmitted by a Serializer, in particular the Serializer 4, starting from serial data 5s in input.

The Deserializer 8 is also mostly known to those skilled in the art.

In fact, it includes at least one second Shift Register **81.** The second Shift Register 81 comprises second flip-flops **82** cascaded. The second flip-flops 82 are substantially 1 bit memory cells arranged in a chain. The second Shift register 81 is substantially configured to shift the bits from one cell to the one immediately adjacent to each clock pulse.

The Deserializer 8 is preferably operatively connected to the receiving block 6. Furthermore, the Deserializer 8 is configured to receive at least the second serial data 5s and the second high frequency clock signal 5a.

Hence, the Deserializer 8 preferably rearranges the second serial data 5s into the second parallel data 5p. The second parallel data 5p is only higher than the second serial data 5s multiplexed into parallel components of information.

The second data in parallel 5p are, in the Deserializer 8, preferably correlated in frequency to the second high frequency clock signal 5a.

Like any Deserializer, moreover, the Deserializer 8 substantially reorganizes the second serial data 5s into second data in parallel 5p on the basis of a second load signal **8c.**

Usually, the load signal is generated internally in the Deserializer; however, this configuration has important drawbacks, as already mentioned, when the circuit 10 which includes the SIPO device 5 is subjected to radiation.

The second load signal 8c is advantageously not generated internally in the Deserializer 8.

Advantageously, the CDR apparatus 7 includes at least a second FD **70,** or Frequency divider. The second FD 70 is substantially configured to generate at least a second control clock signal **5c** starting from the second high frequency clock signal 5a.

For example, the second control clock signal 5c can be obtained by dividing the frequency value of the clock 5a with the right relationship substantially proportionally and in detail equal to the number of bits of the second data in parallel 5p.

The second FD 70 is therefore operatively connected to the receiving block 6. Furthermore, the second control clock signal 5c coincides with the second low frequency clock signal 5l. In other words, the second low frequency clock signal 5l in input to the receiving block 6 is given by the second control signal 5c. Advantageously, the receiving block 6 transmits the second low-frequency clock signal 5l to the Deserializer 8 so as to determine the second load signal 8c in proportion to the second low-frequency clock signal 5l.

This last aspect is important since, also in this case, the second high frequency signal 5a and the second load signal 5c must have a suitable phase relationship to allow the correct sampling of the data in parallel 5p. This correspondence can also be determined in the SIPO 5 device without resorting to load generators or other additional components sensitive to radiation.

Since, as already said, the second Shift Register 81 is configured to control the shifting of the bits between the second flip-flips 82 during the organization phase of the second serial data 5s into seconds data in parallel 5p, preferably the Deserializer 8 also comprises a second pulse generator module **80.**

The second pulse generator module 80, just like the first pulse generator module 40 with the first FD 30, is operationally connected to the second FD 70. Hence, the second pulse generator module 80 is configured to generate a second pulse **8i** along a clock cycle of the second high-frequency clock signal 5a at each rising edge of the second low-frequency clock signal 5l. This second pulse 8i is therefore given by the second load signal 8c and determines the sliding in the second Shift Register 81.

The integrated circuit 10 preferably comprises both the PISO 1 device and the SIPO 5 device.

In particular, the devices 1, 5 interact with each other. Therefore, preferably, the Serializer 4 is operatively connected to the Deserializer 8 and to the CDR 7 apparatus.

Furthermore, the first serial data 1s coincide with the second serial data 5s.

The first parallel data 1p, consequently, are equivalent to the second parallel data 5p, the first high frequency signals 1a are equivalent to the second high frequency signals 5a and the first low frequency signals 1l are equivalent to the second low frequency signals 5l.

It is emphasized that the term "coincides" as in the case of the first serial data 1s which coincide with the second serial data 5s means that the second serial data 5s are the first serial data 1s, that is, they are the same data that is transmitted between the Serializer 4 and Deserializer 8.

When, on the other hand, we speak of "equivalence", as in the case of the first low-frequency signals 1l which are equivalent to the second low-frequency signals 5l, we mean that the signals correspond, that is, they have the same function and same value, but they are not the same data. In fact, for example, the second low frequency signal 5l is the result of the processing by the CDR apparatus of the second high frequency signal 5a reconstructed from the serial data 1s, 5s and is not directly transmitted from the PISO 1 device to the SIPO 5 device.

In the circuit 10, moreover, they can be implemented by additional elements, known to the current technical state, to improve the transmission of data. For example, the circuit 10 may include a correction device operatively connected to Serializer 4 and Deserializer 8 and configured to implement EDAC type logics for detecting and correcting transmission errors of serial data 1s, 5s due to noise.

Even more in detail, the connection between Serializer 4 and Deserializer 8 can be configured according to particular logics.

Preferably, at least one transmitter flip-flop **43** can be identified among the first flip-flops 42. At least one receiver flip-flop **83** can be identified among the second flip-flops 82.

The transmitter 43 and receiver 83 flip-flops are, therefore, mutually operationally connected for the exchange of data between Serializer 4 and Deserializer 8.

Moreover, even more in detail, at least the transmitter 43 and receiver 83 flip-flops are connected with digital logic Current Mode Logic type, also known to those skilled in the art as CML.

Preferably, also within the rest of the PISO 1 and SIPO 5 devices the signals are of the CML type.

The CML is a differential digital logic and, therefore, provides for point-to-point, unidirectional transmission, which usually ends at its destination with 50 Ω resistors on both differential lines.

To implement the CML, preferably, the transmitter flip-flop 43 includes a first transistor **430.**

The first transistor 430 is preferably configured to receive a logic level 1 signal corresponding to a first voltage signal **10s,** starting from the first serial data 1s. Furthermore, the transmitter flip-flop 43 includes a second transistor **431** configured to receive a logic level 0 signal to which corresponds a second voltage signal **11s** starting from the first serial data 1s.

In addition, the transmitter flip-flop 43 includes a transistor control **432.**

The transmitter flip-flop 43 is configured to receive a control voltage **4b.**

In detail, the control voltage 4b is applied to the control transistor 432 and is capable of determinining, by working the control transistor 432 in saturation, a control current **4a** which flows in the first transistor 430 or in the second transistor 431 and which generates on the output resistance the required voltage level.

These elements are substantially common to the flip-flops used in the PISO 1 and SIPO 5 devices and can, therefore, be present on all flip-flops 42, 82, 43, 83.

In general, all flip-flops include differential structures based on pairs of transistors, such as the first and second transistors 430 and 431. At each clock cycle only one of the two transistors, driven by the signal corresponding to the logic level 1, is in conduction, while the other, driven by the signal corresponding to the logic level 0, it is off.

Advantageously, the transmitter flip-flop 43 also comprises a compensation device **433.**

The compensation device 433 is preferably operationally connected to the first transistor 430 and to the control transistor 432.

It is, therefore, configured to vary the control voltage 4b in proportion to the variation of the first voltage signal 10s.

More in detail, the compensation device 433 is operatively connected to the gate of the first drain voltage signal 10s of the transistor 430 driven by a signal corresponding to a high logic level in a monitoring flip flop. It compares the first voltage signal 10a on the drain of the first transistor 430 with a predetermined reference voltage value **4p** provided by the design specifications and varies the control voltage 4b of the control transistor 432 so as to obtain the expected value. In order to realize this function, the compensation device 433 can be realized in various ways.

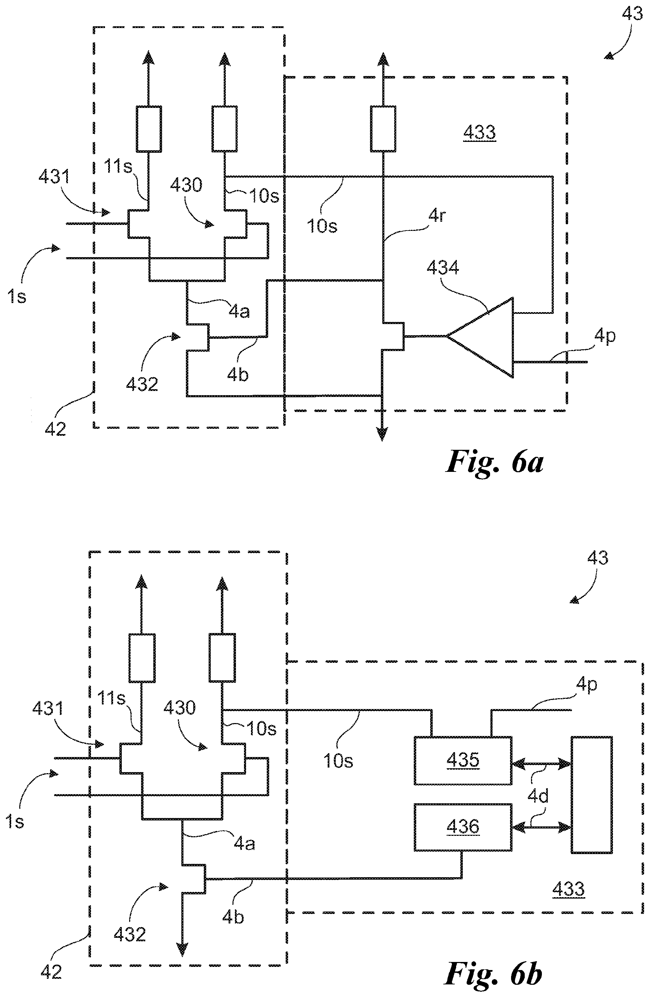

In a preferred embodiment, shown in Fig. 6a, the compensation device 433 is configured to receive a reference current **4r** and to modulate the value of the reference current 4r to determine the control voltage 4b.

The compensation device 433 therefore includes a comparator **434.** The latter is preferably configured to modulate the reference current 4r on the basis of the voltage difference detected between the predetermined reference voltage 4p and the first voltage signal 10s.

In an alternative embodiment, shown in Fig. 6b, the compensation device 433 is configured to receive a predetermined reference voltage 4p and the first voltage signal 10s.

Furthermore, the compensation device 433 includes an digital analog converter **435,** also known as ADC, and a digital analog converter **436,** also known as DAC, operatively connected to said digital analog converter 435.

The digital analog converter 435 is substantially configured to measure the voltage difference detected between the predetermined reference voltage 4p and the first voltage signal 10s and generate a differential signal 4d.

The digital analog converter 436 is, therefore, configured to receive the differential signal 4d and regulate the control voltage 4b proportionally to the differential signal 4d.

In summary, the compensation device 433 is able to compensate for the degradative effects, especially deriving from TID, which lead to malfunctions and reductions in the efficiency of the circuits.

The operation of the circuit 10 previously described in structural terms is substantially similar to the operation of common circuits with significant differences in performance.

The improved integrated circuit for driving fast links in radiation-hard applications 1 according to the invention, in fact, achieves important advantages.

In fact, the improved integrated circuit 10 is able to mitigate, in an efficient manner, the effects of deterioration deriving from radiations which strike the circuit, in particular both SEE and TID. Furthermore, the improved integrated circuit 10 has a high robustness without implementing redundant logics. Thus, the circuit 10 reduces non-essential space or energy dissipations.

In conclusion, the circuit 10 is able, above all thanks to the compensation device 433, to autonomously restore its own functionality, for example in the event of a block due to TID.

The invention is susceptible of variants falling within the scope of the inventive concept defined by the claims.

In this context, all the details can be replaced by equivalent elements and the materials, shapes and dimensions can be any.

## Claims

1. Improved integrated circuit (10) for driving fast links in radiation-hard applications comprising a
Parallel In Serial Out device (1) comprising:
- a transmitting block (2) defining a first basic logic and configured to transmit first data in parallel (1p) correlated to a first low frequency clock signal (11),
- a phase-Locked-Loop device, PLL, (3) configured to receive a first clock signal reference(1r) and to generate at least a first high frequency clock signal (1a) and including at least a first Frequency divider (30) configured to generate at least a first control clock signal (1c) starting from said first high frequency clock signal (1a) and to control said first high frequency clock signal (1a) as feedback by comparing in phase said first reference clock signal (1r) and a first comparison clock signal (1f) derived from said first control clock signal (1c),
- a Serializer (4) operatively connected to said PLL (3) and said transmitting block (2) and configured to receive at least said first data in parallel (1p) and said first high frequency clock signal (1a) and reorganize said first data in parallel (1p) on the basis of a first load signal (4c) into first serial data (1s) related in frequency to said first high frequency clock signal (1a),
- said at least one first Frequency divider (30) is operatively connected to said block transmitter (2), said first low frequency clock signal (1l) coincides with said first control clock signal (1c) and said transmitting block (2) is configured to transmit said first low frequency clock signal (1l) to said Serializer (4) so as to determine said first load signal (4c) in proportion to said first low frequency clock signal (1l),
a Serial In Parallel Out device (5) comprising:
- a receiving block (6) defining a second basic logic and configured to receive second data in parallel (5p) correlated to a second low frequency clock signal (5l),
- a Clock and Data Recovery, CDR, apparatus (7) configured to receive second serial data (5s), to generate at least a second high frequency clock signal (5a) and to control said second high frequency clock signal (5a) as feedback by comparing in phase said second high frequency clock signal (5a) and said second serial data (5s), and in including at least one second Frequency divider (70) configured to generate at least one second control clock signal (5c) starting from said second high frequency clock signal (5a),
- a Deserializer (8) operatively connected to said CDR apparatus (7) and said receiving block (6) and configured to receive at least said second serial data (5s) and said second high frequency clock signal (5a) and reorganize said second serial data (5s) according to a second load signal (8c) in said second parallel data (5p) related in frequency to said second high frequency clock signal (5a),
- said at least one second Frequency divider (70) is operatively connected to said receiving block (6), said second low frequency clock signal (5l) coincides with said second control clock signal (5c) and said receiving block (6) is configured to transmit said second low frequency clock signal (5l) to said Deserializer (8) so as to determine said second load signal (8c) in proportion to said second low frequency clock signal (5l).
wherein said Serializer (4) is operatively connected to said Deserializer (8) and said CDR apparatus (7), said first serial data (1s) coincide with said second serial data (5s), said first data in parallel (1p) are equivalent to said second data in parallel (5p), said first high frequency clock signals (1a) are equivalent to said second high frequency clock signals (5a) and said first low frequency clock signals (1l) are equivalent to said second low frequency clock signals (5l);
said Serializer (4) including a first shift register (41) comprising first flip-flops (42) in cascade and said Deserializer (8) including a second Shift Register (81) comprising second flip-flops (82) in cascade, said first flip-flops (42) including at least one flip-flop transmitter (43) and said second flip-flops (82) including at least one receiver flip-flop (83) operatively connected to said at least one flip-flop transmitter (43) with differential
digital logic of the Current-Mode Logic type;
**characterized by that**
said at least one flip-flop transmitter (43) includes a first transistor (430) configured to receive a logic level 1 signal which corresponds to a first voltage signal (10s) starting from said first data serial (1s), a second transistor (431) configured to receive a signal logic level 0 signal which corresponds to a second voltage signal (11s) starting from said first serial data (1s), a control transistor (432) configured to receive a control voltage (4b) which is applied to the control transistor (432) and to determine said control transistor (432) working in saturation, a control current (4a) of said flip-flop transmitter (43) and a compensation device (433) operatively connected to said first transistor (430) and said control transistor (432) and configured to compare said first voltage signal (10s) of said first transistor (430) with a predetermined reference voltage value (4p) and varying said control voltage (4b) proportionally to the variation of said first voltage signal (10s).

2. Improved integrated circuit (10) according to claim 1, wherein said Serializer (4) comprises a first pulse generator module (40) operatively connected to said at least one first Frequency divider (30) and configured to generate a first pulse (4i) along a clock cycle of said first high frequency clock signal (1a) at each rising edge of said first low frequency clock signal (1l).

3. Improved integrated circuit (10) according to claim 1, wherein said Deserializer (8) comprises a second pulse generator module (80) operatively connected to said at least one second Frequency divider (70) and configured to generate a second pulse (8i) along a clock cycle of said second high frequency clock signal (5a) at each rising edge of said second low frequency clock signal (5l).

4. Improved integrated circuit (10) according to claim 1, comprising a correction device operatively connected to said Serializer (4) and said Deserializer (8) and configured to implement EDAC type logics to detect and correct transmission errors of said first and second serial data (1s, 5s) due to noise.

5. Improved integrated circuit (10) according to any one of claims 1 or 4, wherein said compensation device (433) is configured to receive a reference current (4r) to determine said control voltage (4b), said predetermined reference voltage (4p) and said first voltage signal (10s) and includes a comparator (434) configured to modulate said reference current (4r) on the basis difference of the voltage detected between said predetermined reference voltage (4p) and said **first** voltage signal (10s).

6. Improved integrated circuit (10) according to any one of claims 1 or 4, wherein said compensation device (433) is configured for receiving said predetermined reference voltage (4p) and said first voltage signal (10s) and includes a digital analog converter (435) configured to measure the voltage difference detected between said predetermined reference voltage (4p) and said first voltage signal (10s) and generate a differential signal (4d) and a digital analog converter (436) operatively connected to said digital analog converter (435) and configured to receive said differential signal (4d) and regulate said control voltage (4b) proportionally to said differential signal (4d).

## Patentansprüche

1. Verbesserte integrierte Schaltung (10) zum Ansteuern schneller Verbindungen in strahlungsgehärteten Anwendungen, umfassend eine Parallel In Serial Out Vorrichtung (1), umfassend:
- einen Sendeblock (2), der eine erste Grundlogik definiert und dazu konfiguriert ist, erste Daten in parallel (1p) zu übertragen, die mit einem ersten Niedrigfrequenz-Taktsignal (1l) in Beziehung stehen,
- eine Phase-Locked-Loop Vorrichtung, PLL, (3), die dazu konfiguriert ist, eine erste Taktsignal-Referenz (1r) zu empfangen und mindestens ein erstes Hochfrequenz-Taktsignal (1a) zu erzeugen und umfassend mindestens einen ersten Frequenzteiler (30), der dazu konfiguriert ist, mindestens ein erstes Steuer-Taktsignal (1c) ausgehend von dem ersten Hochfrequenz-Taktsignal (1a) zu erzeugen und das erste Hochfrequenz-Taktsignal (1a) als Feedback zu steuern, indem das erste Referenz-Taktsignal (1r) und ein erstes Vergleichs-Taktsignal (1f), das aus dem ersten Steuer-Taktsignal (1e) abgeleitet wird, in Phase verglichen werden,
- einen Serialisierer (4), der operativ mit der PLL (3) und dem Sendeblock (2) verbunden ist und dazu konfiguriert ist, mindestens die ersten Daten in parallel (1p) und das erste Hochfrequenz-Taktsignal (1a) zu empfangen und die ersten Daten in parallel (1p) basierend auf einem ersten Ladesignal (4c) in erste serielle Daten (1s) zu reorganisieren, die in Frequenz mit dem ersten Hochfrequenz-Taktsignal (1a) im Zusammenhang sind,
- der mindestens eine erste Frequenzteiler (30) ist operativ mit dem Blocksender (2) verbunden, das erste Niedrigfrequenz-Taktsignal (1l) stimmt mit dem ersten Steuer-Taktsignal (1e) überein und der Sendeblock (2) ist dazu konfiguriert, das erste Niedrigfrequenz-Taktsignal (1l 44) an den Serialisierer (4) zu übertragen, um das erste Ladesignal (4c) im Verhältnis zu dem ersten Niedrigfrequenz-Taktsignal (1l) zu bestimmen,
- eine Serial In Parallel Out Vorrichtung (5), umfassend:
- einen Empfangsblock (6), der eine zweite Grundlogik definiert und dazu konfiguriert ist, zweite Daten in parallel (5p) zu empfangen, die mit einem zweiten Niedrigfrequenz-Taktsignal (5l) in Beziehung stehen,
- eine Clock and Data Recovery, CDR, Vorrichtung (7), die dazu konfiguriert ist, zweite serielle Daten (5s) zu empfangen, mindestens ein zweites Hochfrequenz-Taktsignal (5a) zu erzeugen und das zweite Hochfrequenz-Taktsignal (5a) als Feedback zu steuern, indem das zweite Hochfrequenz-Taktsignal (5a) und die zweiten seriellen Daten (5s) in Phase verglichen werden, und umfassend mindestens einen zweiten Frequenzteiler (70), der dazu konfiguriert ist, mindestens ein zweites Steuer-Taktsignal (5c) ausgehend von dem zweiten Hochfrequenz-Taktsignal (5a) zu erzeugen,
- einen Deserialisierer (8), der operativ mit der CDR Vorrichtung (7) und dem Empfangsblock (6) verbunden ist und dazu konfiguriert ist, mindestens die zweiten seriellen Daten (5s) und das zweite Hochfrequenz-Taktsignal (5a) zu empfangen und die zweiten seriellen Daten (5s) nach einem zweiten Ladesignal (8c) in die zweiten parallelen Daten (5p) zu reorganisieren, die in Frequenz mit dem zweiten Hochfrequenz-Taktsignal (5a) im Zusammenhang sind,
- der mindestens eine zweite Frequenzteiler (70) ist operativ mit dem Empfangsblock (6) verbunden, das zweite Niedrigfrequenz-Taktsignal (5l) stimmt mit dem zweiten Steuer-Taktsignal (5c) überein und der Empfangsblock (6) ist dazu konfiguriert, das zweite Niedrigfrequenz-Taktsignal (5l) an den Deserialisierer (8) zu übertragen, um das zweite Ladesignal (8c) im Verhältnis zu dem zweiten Niedrigfrequenz-Taktsignal (5l) zu bestimmen.
wobei der Serialisierer (4) operativ mit dem Deserialisierer (8) und der CDR Vorrichtung (7) verbunden ist, die ersten seriellen Daten (1s) mit den zweiten seriellen Daten (5s) übereinstimmen, die ersten Daten in parallel (1p) den zweiten Daten in parallel (5p) entsprechen, die ersten Hochfrequenz-Taktsignale (1a) den zweiten Hochfrequenz-Taktsignalen (5a) entsprechen und die ersten Niedrigfrequenz-Taktsignale (1l) den zweiten Niedrigfrequenz-Taktsignalen (5l) entsprechen;
der Serialisierer (4) umfassend einen ersten Schieberegister (41) umfassend erste Flip-Flops (42) in Kaskade und der Deserialisierer (8) umfassend einen zweiten Schieberegister (81) umfassend zweite Flip-Flops (82) in Kaskade, wobei die ersten Flip-Flops (42) mindestens einen Flip-Flop Sender (43) umfassen und die zweiten Flip-Flops (82) mindestens einen Flip-Flop Empfänger (83) umfassen, der operativ mit dem mindestens einen Flip-Flop Sender (43) mit differentieller digitaler Logik vom Typ Current-Mode Logic verbunden ist; **dadurch gekennzeichnet, dass**
der mindestens eine Flip-Flop Sender (43) einen ersten Transistor (430) umfasst, der dazu konfiguriert ist, ein Logikpegel-1-Signal zu empfangen, das einem ersten Spannungssignal (10s) ausgehend von den ersten seriellen Daten (1s) entspricht, einen zweiten Transistor (431), der dazu konfiguriert ist, ein Logikpegel-0-Signal zu empfangen, das einem zweiten ersten Spannungssignal (11s) ausgehend von den ersten seriellen Daten (1s) entspricht, einen Steuertransistor (432), der dazu konfiguriert ist, eine Steuerspannung (4b) zu empfangen, die an den Steuertransistor (432) angelegt ist und zu bestimmen, das der Steuertransistor (432) sich im Sättigungsbetrieb befindet, einen Steuerstrom (4a) des Flip-Flops Senders (43) und eine Kompensationsvorrichtung (433), die operativ mit dem ersten Transistor (430) und dem Steuertransistor (432) verbunden ist und dazu konfiguriert ist, das erste Spannungssignal (10s) des ersten Transistors (430) mit einem vorbestimmten Referenzspannungswert (4p) zu vergleichen und die Steuerspannung (4b) im Verhältnis zu der Änderung des ersten Spannungssignals (10s) zu ändern.

2. Verbesserte integrierte Schaltung (10) nach Anspruch 1, wobei der Serialisierer (4) ein erstes Impulsgeneratormodul (40) umfasst, das operativ mit dem mindestens einen ersten Frequenzteiler (30) verbunden ist und dazu konfiguriert ist, einen ersten Impuls (4i) entlang eines Taktzyklus des ersten Hochfrequenz-Taktsignals (1a) bei jeder steigenden Flanke des ersten Niedrigfrequenz-Taktsignals (1l) zu erzeugen.

3. Verbesserte integrierte Schaltung (10) nach Anspruch 1, wobei der Deserialisierer (8) ein zweites Impulsgeneratormodul (80) umfasst, das operativ mit dem mindestens einen zweiten Frequenzteiler (70) verbunden ist und dazu konfiguriert ist, einen zweiten Impuls (8i) entlang eines Taktzyklus des zweiten Hochfrequenz-Taktsignals (5a) bei jeder steigenden Flanke des zweiten Niedrigfrequenz-Taktsignals (5l) zu erzeugen.

4. Verbesserte integrierte Schaltung (10) nach Anspruch 1, umfassend eine Korrekturvorrichtung, die operativ mit dem Serialisierer (4) und dem Deserialisierer (8) verbunden ist und dazu konfiguriert ist, Logiken vom Typ EDAC zu implementieren, um Übertragungsfehler der ersten und der zweiten seriellen Daten (1s, 5s) aufgrund von Rauschen zu erfassen und zu korrigieren.

5. Verbesserte integrierte Schaltung (10) nach einem der Ansprüche 1 oder 4, wobei die Kompensationsvorrichtung (433) dazu konfiguriert ist, einen Referenzstrom (4r) zu empfangen, um die Steuerspannung (4b), die vorbestimmte Referenzspannung (4p) und das erste Spannungssignal (10s) zu bestimmen, und einen Vergleicher (434) umfasst, der dazu konfiguriert ist, den Referenzstrom (4r) basierend auf der Spannungsdifferenz zwischen der vorbestimmten Referenzspannung (4p) und dem ersten Spannungssignal (10s) zu modulieren.

6. Verbesserte integrierte Schaltung (10) nach einem der Ansprüche 1 oder 4, wobei die Kompensationsvorrichtung (433) dazu konfiguriert ist, die vorbestimmte Referenzspannung (4p) und das erste Spannungssignal (10s) zu empfangen und einen Digital-Analog-Wandler (435), der dazu konfiguriert ist, die Spannungsdifferenz zwischen der vorbestimmten Referenzspannung (4p) und dem ersten Spannungssignal (10s) zu messen und ein differentielles Signal (4d) zu erzeugen und einen Digital-Analog-Wandler (436), der operativ mit dem Digital-Analog-Wandler (435) verbunden ist und dazu konfiguriert ist, das differentielle Signal (4d) zu empfangen und die Steuerspannung (4b) im Verhältnis zu dem differentiellen Signal (4d) einzustellen, umfasst.

## Revendications

1. Circuit intégré amélioré (10) pour piloter des liaisons rapides dans des applications durcies aux radiations comprenant un
dispositif Parallel In Serial Out (1) comprenant :
- un bloc d'émission (2) définissant une première logique de base et configuré pour transmettre des premières données en parallèle (1p) corrélées à un premier signal d'horloge à basse fréquence (11),
- un dispositif Phase-Locked-Loop, PLL, (3) configuré pour recevoir un premier signal de référence d'horloge (1r) et pour générer au moins un premier signal d'horloge à haute fréquence (1a) et comprenant au moins un premier diviseur de fréquence (30) configuré pour générer au moins un premier signal d'horloge de contrôle (1e) à partir dudit premier signal d'horloge à haute fréquence (1a) et pour contrôler ledit premier signal d'horloge à haute fréquence (1a) en rétroaction en comparant en phase ledit premier signal de référence d'horloge (1r) et un premier signal d'horloge de comparaison (1f) dérivé dudit premier signal d'horloge de contrôle (1e),
- un sérialiseur (4) connecté de manière opérative audit PLL (3) et audit bloc d'émission (2) et configuré pour recevoir au moins lesdites premières données en parallèle (1p) et ledit premier signal d'horloge à haute fréquence (1a) et réorganiser lesdites premières données en parallèle (1p) sur la base d'un premier signal de chargement (4c) en premières données série (1s) liées en fréquence audit premier signal d'horloge à haute fréquence (1a),
- ledit au moins un premier diviseur de fréquence (30) est connecté de manière opérative audit bloc d'émission (2), ledit premier signal d'horloge à basse fréquence (11) coïncide avec ledit premier signal d'horloge de contrôle (1e) et ledit bloc d'émission (2) est configuré pour transmettre ledit premier signal d'horloge à basse fréquence (11) audit sérialiseur (4) de manière à déterminer ledit premier signal de chargement (4c) proportionnellement audit premier signal d'horloge à basse fréquence (11),
un dispositif Serial In Parallel Out (5) comprenant :
un bloc de réception (6) définissant une seconde logique de base et configuré pour recevoir des secondes données en parallèle (5p) corrélées à un second signal d'horloge à basse fréquence (51),
un appareil Clock and Data Recovery, CDR, (7) configuré pour recevoir des secondes données série (5s), pour générer au moins un second signal d'horloge à haute fréquence (5a) et pour contrôler ledit second signal d'horloge à haute fréquence (5a) en rétroaction en comparant en phase ledit second signal d'horloge à haute fréquence (5a) et lesdites secondes données série (5s), et comprenant au moins un second diviseur de fréquence (70) configuré pour générer au moins un second signal d'horloge de contrôle (5c) à partir dudit second signal d'horloge à haute fréquence (5a),
un désérialiseur (8) connecté de manière opérative audit appareil CDR (7) et audit bloc de réception (6) et configuré pour recevoir au moins lesdites secondes données série (5s) et ledit second signal d'horloge à haute fréquence (5a) et réorganiser lesdites secondes données série (5s) selon un second signal de chargement (8c) en lesdites secondes données en parallèle (5p) liées en fréquence audit second signal d'horloge à haute fréquence (5a),
ledit au moins un second diviseur de fréquence (70) est connecté de manière opérative audit bloc de réception (6), ledit second signal d'horloge à basse fréquence (5l) coïncide avec ledit second signal d'horloge de contrôle (5c) et ledit bloc de réception (6) est configuré pour transmettre ledit second signal d'horloge à basse fréquence (5l) audit désérialiseur (8) de manière à déterminer ledit second signal de chargement (8c) proportionnellement audit second signal d'horloge à basse fréquence (5l).
dans lequel ledit sérialiseur (4) est connecté de manière opérative audit désérialiseur (8) et audit appareil CDR (7), lesdites premières données série (1s) coïncident avec lesdites secondes données série (5s), lesdites premières données en parallèle (1p) sont équivalentes auxdites secondes données en parallèle (5p), lesdits premiers signaux d'horloge à haute fréquence (1a) sont équivalents auxdits seconds signaux d'horloge à haute fréquence (5a) et lesdits premiers signaux d'horloge à basse fréquence (11) sont équivalents auxdits seconds signaux d'horloge à basse fréquence (51) ;
ledit sérialiseur (4) comprenant un premier registre à décalage (41) comprenant des premiers bascules (42) en cascade et ledit désérialiseur (8) comprenant un second registre à décalage (81) comprenant des secondes bascules (82) en cascade, lesdites premières bascules (42) comprenant au moins une bascule d'émission (43) et lesdites secondes bascules (82) comprenant au moins une bascule de réception (83) connectée de manière opérative audit au moins une bascule d'émission (43) avec une logique numérique différentielle du type Current-Mode Logic ;
**caractérisé en ce que**
ladite au moins une bascule d'émission (43) comprend un premier transistor (430) configuré pour recevoir un signal de niveau logique 1 qui correspond à un premier signal de tension (10s) à partir desdites premières données série (1s), un second transistor (431) configuré pour recevoir un signal de niveau logique 0 qui correspond à un second premier signal de tension (11s) à partir desdites premières données série (1s), un transistor de contrôle (432) configuré pour recevoir une tension de contrôle (4b) qui est appliquée au transistor de contrôle (432) et pour déterminer ledit transistor de contrôle (432) fonctionnant en saturation, un courant de contrôle (4a) de ladite bascule d'émission (43) et un dispositif de compensation (433) connecté de manière opérative audit premier transistor (430) et audit transistor de contrôle (432) et configuré pour comparer ledit premier signal de tension (10s) dudit premier transistor (430) avec une valeur de tension de référence prédéterminée (4p) et faire varier ladite tension de contrôle (4b) proportionnellement à la variation dudit premier signal de tension (10s).

2. Circuit intégré amélioré (10) selon la revendication 1, dans lequel ledit sérialiseur (4) comprend un premier module générateur d'impulsions (40) connecté de manière opérative audit au moins un premier diviseur de fréquence (30) et configuré pour générer une première impulsion (4i) le long d'un cycle d'horloge dudit premier signal d'horloge à haute fréquence (1a) à chaque front montant dudit premier signal d'horloge à basse fréquence (11).

3. Circuit intégré amélioré (10) selon la revendication 1, dans lequel ledit désérialiseur (8) comprend un second module générateur d'impulsions (80) connecté de manière opérative audit au moins un second diviseur de fréquence (70) et configuré pour générer une seconde impulsion (8i) le long d'un cycle d'horloge dudit second signal d'horloge à haute fréquence (5a) au niveau de chaque front montant dudit second signal d'horloge à basse fréquence (51).

4. Circuit intégré amélioré (10) selon la revendication 1, comprenant un dispositif de correction connecté de manière opérative audit sérialiseur (4) et audit désérialiseur (8) et configuré pour mettre en œuvre des logiques de type EDAC pour détecter et corriger des erreurs de transmission desdites premières et secondes données série (1s, 5s) dues au bruit.

5. Circuit intégré amélioré (10) selon l'une quelconque des revendications 1 ou 4, dans lequel ledit dispositif de compensation (433) est configuré pour recevoir un courant de référence (4r) pour déterminer ladite tension de contrôle (4b), ladite tension de référence prédéterminée (4p) et ledit premier signal de tension (10s) et comprend un comparateur (434) configuré pour moduler ledit courant de référence (4r) sur la base de la différence de tension détectée entre ladite tension de référence prédéterminée (4p) et ledit premier signal de tension (10s).

6. Circuit intégré amélioré (10) selon l'une quelconque des revendications 1 ou 4, dans lequel ledit dispositif de compensation (433) est configuré pour recevoir ladite tension de référence prédéterminée (4p) et ledit premier signal de tension (10s) et comprend un convertisseur numérique analogique (435) configuré pour mesurer la différence de tension détectée entre ladite tension de référence prédéterminée (4p) et ledit premier signal de tension (10s) et générer un signal différentiel (4d) et un convertisseur numérique analogique (436) connecté de manière opérative audit convertisseur numérique analogique (435) et configuré pour recevoir ledit signal différentiel (4d) et réguler ladite tension de contrôle (4b) proportionnellement audit signal différentiel (4d).
